Europäisches Patentamt

European Patent Office

Office européen des brevets

(11) Veröffentlichungsnummer: **0 254 168**
A2

(12) **EUROPÄISCHE PATENTANMELDUNG**

(21) Anmeldenummer: 87110061.6

(51) Int. Cl.³: **H 01 J 37/34**

(22) Anmeldetag: 11.07.87

(30) Priorität: 19.07.86 DE 3624480

(43) Veröffentlichungstag der Anmeldung:
27.01.88 Patentblatt 88/4

(84) Benannte Vertragsstaaten:
CH DE FR GB LI NL

(71) Anmelder: Leybold-Heraeus GmbH
Bonner Strasse 498 Postfach 51 07 60
D-5000 Köln 51(DE)

(72) Erfinder: Wirz, Peter Dr.
Klosterstrasse 5,
D-6296 Waldernbach(DE)

(72) Erfinder: Bräuer, Günter Dr.
Hauptstrasse 22,
D-6464 Linsengericht 5(DE)

(74) Vertreter: Zapfe, Hans, Dipl.-Ing.
Seestrasse 2 Postfach 30 04 08
D-6054 Rodgau-3(DE)

(54) Zerstäubungskatode für Vakuum-Beschichtungsanlagen.

(57) Zerstäubungskatode (1) mit einer Dunkelraumab-schirmung (14) für Vakuumbeschichtungsanlagen mit einem metallischen Katodengrundkörper (5) und mit einem auf diesem durch Bonden befestigten nicht-metallischen Target (12). Dabei ist eine zwischen Katodengrundkörper (5) und Target (12) gebildete, mit Bond-Material gefüllte Nahtstelle (16) an einem nicht der Glimmentladung ausgesetzten Ort angeordnet. Zur Lösung der Aufgabe, Spannungsüberschl-äge im Bereich der Nahtstelle (16) gegenüber Masse zu ver-meiden, ist die Nahtstelle (16) auf dem gesamten Umfang des nicht-metallischen Targets (12) durch einen auf Katoden-potential liegenden metallischen Rahmen (13) abgedeckt, der gegenüber dem Target (12) eine nicht mit Bond-Material gefüllte Trennfuge (17) zwischen metallischem und nicht-metallischem Material bildet.

FIG.1

- 1 -

LEYBOLD-HERAEUS   G m b H

Bonner Straße 498

D-5000 Köln - 51

-------------------------------------------------------------

" Zerstäubungskatode für Vakuum-Beschichtungsanlagen "

-------------------------------------------------------------

Die Erfindung betrifft eine Zerstäubungskatode mit einer
Dunkelraumabschirmung für Vakuum-Beschichtungsanlagen
mit einem metallischen Katodengrundkörper und mit einem
durch Bonden auf diesem befestigten Target, das mindestens
teilweise, insbesondere an seiner Oberfläche, aus einem
nicht-metallischen Werkstoff besteht, wobei eine
zwischen Katodengrundkörper und Target gebildete mit
Bondmaterial gefüllte Nahtstelle an einem nicht der
Glimmentladung ausgesetzten Ort angeordnet ist.

Bei der Dunkelraumabschirmung handelt es sich um eine aus Metall bestehende Umhüllung der nicht der Zerstäubung dienenden Oberflächenteile der Katode, in der Regel also der Seitenflächen und der Rückseite der Katode. Die Dunkelraumabschirmung befindet sich in der Regel auf Massepotential und hat von den benachbarten Flächen der Katode einen Abstand, der kleiner ist als der sich unter den Betriebsbedingungen einstellende Crook'sche Dunkelraumabstand.

Bei den hier zur Diskussion stehenden Targets handelt es sich um Formkörper bzw. Platten aus dem zu zerstäubenden Werkstoff, der ein Nichtleiter bzw. ein Dielektrikum sein kann wie eines der üblichen Metalloxide, oder ein Halbleiter wie beispielsweise Silizium.

Bei den eingangs beschriebenen Zerstäubungskatoden, insbesondere bei den in der Detailbeschreibung noch näher erläuterten Magnetronkatoden, werden die Targets auf einem metallischen Katodengrundkörper befestigt, der beispielhaft aus Kupfer oder Edelstahl bestehen kann und mit Hohlräumen zur Durchleitung eines Kühlmediums versehen ist.

Während es bei metallischen, d.h. in der Regel gut wärmeleitenden Targets üblich ist, diese mittels sogenannter Pratzleisten oder Überwurfringe und Schrauben auf dem Katodengrundkörper zu befestigen (DE-OS 31 35 208 und US-PS 4 500 409), hat es sich bei nicht-metallischen, d.h. in der Regel schlecht wärmeleitenden Targets durchgesetzt, diese durch Bonden (eine Art Lötverfahren) auf dem Katodengrundkörper zu befestigen. -

Beim Bonden ergibt sich notwendigerweise an der Verbindungsfläche zwischen Katodengrundkörper und Target eine Nahtstelle die mit Bondmaterial ausgefüllt ist und die man bisher innerhalb der Dunkelraumabschirmung angeordnet hat, damit sie nicht der Glimmentladung ausgesetzt wird. Diese Maßnahme hat sich jedoch aus den nachstehend noch näher erläuterten Gründen für einen langzeitigen Zerstäubungsprozeß mit konstanten Betriebsparametern als sehr ungenügend erwiesen.

Üblicherweise können die Zerstäubungskatoden sowohl mit Gleichspannung (DC) als auch mit Hochfrequenz (HF) betrieben werden.

Werden bei einem HF-Prozeß Targets der oben beschriebenen Art verwendet, also solche, die zumindest örtlich aus nicht oder nur schlecht leitenden Materialien bestehen, so tritt während des Betriebes zwischen dem Target und dem Katodengrundkörper, d.h. an der angegebenen "Nahtstelle", eine Potentialdifferenz auf. Sobald diese eine kritische Grösse überschreitet, entsteht ein Ladungsausgleich in Form eines Funkens oder Überschlags. Da sich die kritische Nahtstelle üblicherweise in unmittelbarer Nähe der Dunkelraumabschirmung befindet, wird der Funken in Richtung der größten Potentialdifferenz abgeleitet. Diese befindet sich zwischen Katode und Dunkelraumabschirmung, die sich auf Massepotential befindet. Deshalb führt der plötzliche Ladungsausgleich zu einem Abschalten der Stromversorgung der Zerstäubungskatode, da der Ladungsausgleich zwischen Katode und Massepotential einen Kurzschluß darstellt.

Weiterhin erzeugt die mit diesem Vorgang verbundene Entladung sehr häufig eine zusätzliche Erwärmung an der Nahtstelle und damit eine Freisetzung von Gasen aus dem dort vorhandenen Bond-Material. Der durch die Gasfreisetzung örtlich erhöhte Druck ist dann wieder eine Quelle für eine erneute Entladung, so daß erhebliche Unregelmäßigkeiten im Zerstäubungsprozeß auftreten.

Bei einem DC-Prozeß, d.h. beim Betrieb von Zerstäubungskatoden mit Gleichspannung, sind die gleichen Effekte zu beobachten, wenn das Targetmaterial eine geringere elektrische Leitfähigkeit aufweist als der Katodengrundkörper.

Der Erfindung liegt daher die Aufgabe zugrunde, eine Zerstäubungskatode der eingangs beschriebenen Gattung anzugeben, bei der im Bereich der Nahtstelle zwischen Katodengrundkörper und Target keine Spannungsüberschläge mehr gegen Masse stattfinden können.

Die Lösung der gestellten Aufgabe erfolgt erfindungsgemäß dadurch, daß die Nahtstelle auf dem gesamten Umfang des nicht-metallischen Targets durch einen metallischen Rahmen abgedeckt ist, der auf Katodenpotential liegt und gegenüber dem Target eine nicht mit Bond-Material gefüllte Trennfuge zwischen metallischem und nicht-metallischem Material bildet.

- 5 -

Durch die Ausbildung von Katodengrundkörper und Rahmen aus Metall, d.h. aus einem gegenüber dem Target vielfach besser elektrisch leitfähigen Werkstoff wird wirksam verhindert, daß sich an der Berührungsstelle von Rahmen und Katodengrundkörper eine merkliche Potentialdifferenz ausbildet. Innerhalb der an dieser Stelle vorhandenen Dunkelraumabschirmung können mithin keine Überschläge mehr auftreten.

Notwendigerweise bildet der metallische Rahmen gegenüber dem Target eine Trennfuge, die nicht vollständig geschlossen zu sein braucht. Da im Bereich der Trennfuge jedoch kein Bondmaterial vorhanden ist, das unter dem Einfluß der Glimmentladung zu Gasfreisetzungen führen könnte, kann ein stabiler Zerstäubungsprozeß über sehr lange Zeiträume erhalten bleiben.

Bei der Ausbildung der Zerstäubungskatode als Magnetronkatode läßt sich der Bereich der Glimmentladung bzw. des Plasmas durch den einschnürenden Effekt des Magnetfeldes bzw. des magnetischen Tunnels so begrenzen, daß im Bereich der Trennfuge keine Glimmentladung auftritt Hierdurch wird der erfindungsgemäße Effekt noch sehr weitgehend unterstützt.

Der metallische Rahmen wird dabei bevorzugt aus Kupfer ausgebildet, d.h. aus dem gleichen Werkstoff, aus dem üblicherweise auch der Katodengrundkörper besteht. Es ist aber nicht zwingend erforderlich, einen identischen Werkstoff für Rahmen und Grundkörper zu verwenden; letzterer kann auch beispielsweise aus Edelstahl (18/8-Chrom-Nickel-Stahl) hergestellt werden.

Vorteilhafte weitere Ausgestaltungen des Erfindungsgegenstandes ergeben sich aus den übrigen Unteransprüchen; die Vorteile der betreffenden Merkmale sind in der Detailbeschreibung näher erläutert.

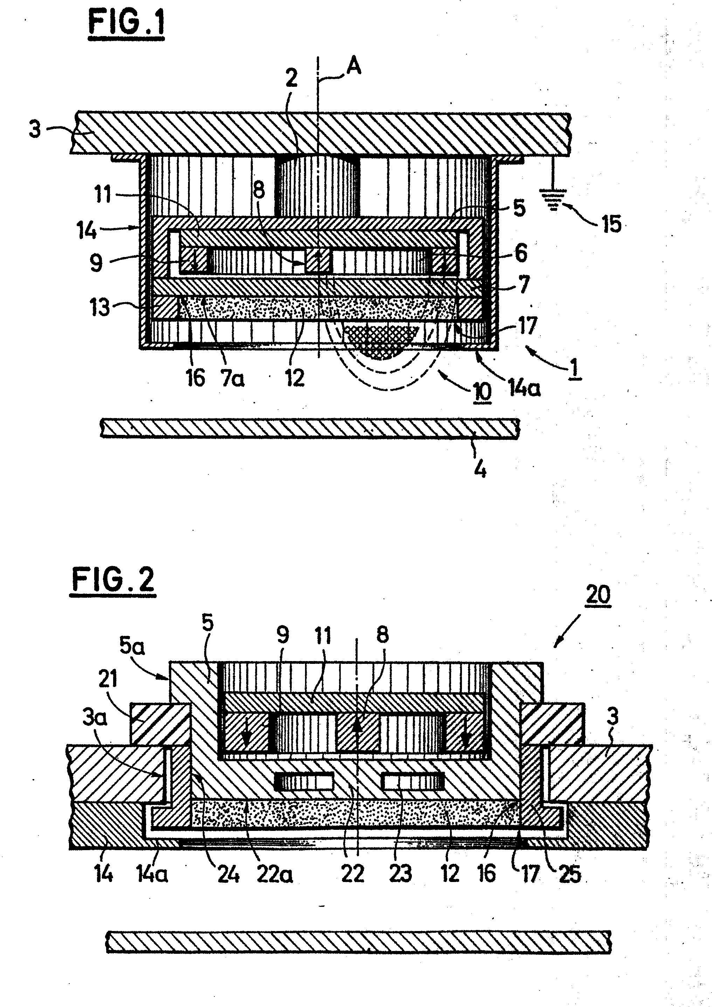

Zwei Ausführungsbeispiele des Erfindungsgegenstandes werden nachstehend anhand der Figuren 1 und 2 näher erläutert.

Es zeigen:

Figur 1    einen Axialschnitt durch eine als Magnetron ausgebildete Zerstäubungskatode, wie sie üblicherweise in eine Vakuumkammer eingesetzt wird, und

Figur 2    einen Axialschnitt analog Figur 1, jedoch durch eine als Magnetron ausgebildete Zerstäubungskatode, wie sie üblicherweise in die Wand einer Vakuumkammer eingesetzt wird.

- 7 -

In Figur 1 ist eine Zerstäubungskatode 1 dargestellt, die von unten mittels einer isolierenden Katodenhalterung 2 an die obere Begrenzungswand 3 einer im Übrigen nicht näher dargestellten Vakuumkammer angesetzt ist, um ein darunterliegendes Substrat 4 zu beschichten.

Die Zerstäubungskatode besteht aus einem Katodengrundkörper 5, dessen Hohlraum 6 in Richtung auf das Substrat 4 durch eine ebene Stirnplatte 7 abgeschlossen ist. Im Hohlraum 6 befindet sich ein Magnetsystem mit einer zentralen Magneteinheit 8 und einer dazu konzentrischen, peripheren Magneteinheit 9, die aus einem Kranz aneinandergereihter Permanentmagnete besteht. Die komplette Zerstäubungskatode 1 ist rotationssymmetrisch aufgebaut, d.h. sie besitzt eine Achse A, die in Normalenrichtung zum Substrat 4 verläuft und im wesentlichen auch die Wanderungsrichtung des zerstäubten Materials bestimmt. Die Magneteinheiten 8 und 9 sind in axialer Richtung magnetisiert, jedoch entgegengesetzt gepolt, was durch die eingezeichneten Pfeile symbolisiert ist. Dadurch entsteht außerhalb der Stirnplatte 7 ein ringförmig geschlossener magnetischer Tunnel 10, von dem die in einem Radialschnitt rechts von der Achse A liegenden Magnetfeldlinien gestrichelt dargestellt sind. Durch diesen magnetischen Tunnel 10 wird ein Plasma eingeschlossen, das durch die kreuzschraffierte Fläche
in der gleichen radialen Schnittebene angedeutet
ist.

Die Magneteinheiten 8 und 9 ruhen mit ihren gegenüberliegenden Polflächen auf einem Magnetjoch 11, um den
magnetischen Fluß zu schliessen.

Zur Kühlung des Systems ist der Hohlraum 6 von Kühlwasser durchströmt.

Die Stirnplatte 7 besitzt eine ebene Stirnfläche 7a,
auf der ein nicht-metallisches Target 12 befestigt
ist. Das Target 12 ist im Durchmesser kleiner als
die Stirnfläche 7a, so daß auf dem Umfang noch eine
Kreisringfläche für die Anbringung eines metallischen
Rahmens 13 freigelassen wird, dessen Außenumfang mit
demjenigen der Stirnplatte 7 zusammenfällt. Dieser
metallische Rahmen ist jedoch keine Pratzleiste bzw.
kein Befestigungsring, da das Target durch Bondmaterial
in gut wärmeleitender Verbindung mit der Stirnplatte 7
steht. Diese Bondverbindung hat außerdem eine sehr
hohe mechanische Festigkeit, so daß beim gesamten
Stand der Technk in solchen Fällen bisher kein
metallischer Rahmen zu finden war.

Die Nahtstelle zwischen der Stirnplatte 7 und dem
Target 12 ist die gemeinsame Berührungsfläche
zwischen diesen beiden Teilen, wobei bei den herkömmlichen Katoden insbesondere der Randbereich der Nahtstelle als kritisch anzusehen ist. Beim Stand der
Technik muß man sich dasjenige Volumen, das durch den
Rahmen 13 eingenommen ist, durch Material des Targets 12
ausgefüllt denken, woraus sich unschwer ergibt, daß alsdann die Nahtstelle bis in die unmittelbare Nähe einer Dunkelraumabschirmung 14 reicht, die sich auf dem gleichen Massepotential 15 befindet, wie die Begrenzungswand 3. Durch die Zurücknahme des Targetrandes auf die angegebene Weise und den Ersatz des freigewordenen Volumens durch den metallischen Rahmen 13 wird der äußere Umfang der Nahtstelle 16 und damit der äußere Rand des Bond-Materials nach innen verlegt, und diese Nahtstelle und damit das Bond-Material wird auf dem gesamten Umfang des Targets 12 durch den genannten metallischen Rahmen 13 abgedeckt. Dadurch entsteht zwar eine neue bzw. weitere Nahtstelle zwischen der Stirnplatte 7 und dem Rahmen 13. Diese Nahtstelle ist jedoch nicht kritisch, da die an dieser Stelle miteinander verbundenen metallischen Teile sehr weitgehend auf gleichem Potential liegen.

Notwendigerweise wird zwischen dem Target 12 und dem Rahmen 13 eine Trennfuge 17 gebildet, die nicht mit Bond-Material gefüllt ist. Die Dunkelraumabschirmung 14 besitzt einen den Rahmen 13 teilweise übergreifenden Flansch 14a, der radial einwärts gerichtet ist. Auf diese Weise wird der Rahmen 13 ebenso wie die übrigen metallischen Teile der Zerstäubungskatode 1 wirksam gegen eine Zerstäubung geschützt, so daß insbesondere das vom Target 12 abgestäubte Material nicht mit anderen Werkstoffen verunreinigt wird. Bevorzugt wird der metallische Rahmen 13 mit dem Katodengrundkörper 5 in dessen Randbereich verschraubt, um ihn leichter auswechseln zu können.

Aus Figur 1 ist noch zu entnehmen, daß das Target 12 und der Rahmen 13 auf der gemeinsamen ebenen Stirnfläche 7a befestigt sind, und daß die Höhe von Target 12 und Rahmen 13 in Normalenrichtung zur Stirnfläche 7a gleich ist. Weiterhin ist noch zu erkennen, daß infolge der Ausbildung der Zerstäubungskatode 1 als Magnetronkatode mit dem beschriebenen Magnetsystem die Trennfuge 17 außerhalb des von dem Magnetsystem gebildeten magnetischen Tunnels 10 bzw. des von diesem eingeschlossenen Plasmas liegt. Auch dadurch wird wirksam verhindert, daß der Rahmen 13 mit zerstäubt wird.

In Figur 2 sind gleiche Teile wie in Figur 1 mit gleichen Bezugszeichen versehen, so daß sich Wiederholungen weitgehend erübrigen. In Abweichung von Figur 1 ist jedoch die obere Begrenzungswand 3 der Vakuumkammer mit einer kreisförmigen Ausnehmung 3a versehen, in die eine Zerstäubungskatode 20 von oben eingesetzt ist. Der Katodengrundkörper 5 besitzt einen flanschförmigen Rand 5a, mit dem er unter Zwischenschaltung eines Isolierkörpers 21 auf die Begrenzungswand 3 aufgesetzt ist. Das aus den Magneteinheiten 8 und 9 und dem Magnetjoch 11 bestehende Magnetsystem stimmt weitgehend mit demjenigen von Figur 1 überein. Eine Stirnplatte 22 ist jedoch im vorliegenden Fall einteilig mit dem Katodengrundkörper 5 ausgebildet und trägt auf ihrer Stirnfläche 22a ein kongruentes Target 12. Die Kühlung erfolgt mittels eines in der Stirnplatte 22 befindlichen Kühlkanals 23. Es ist zu erkennen, daß das Target 12 und der Katodengrundkörper 5 von einer gemeinsamen, zu dessen Stirnfläche 22a senkrecht verlaufenden Umfangsfläche 24 begrenzt sind, die eine Zylinderfläche ist. In dieser Zylinderfläche enden auch die Nahtstelle 16 und das Bond-Material zwischen Katodengrundkörper 5 und Target 12. In Abwandlung von Figur 1 ist jedoch ein metallischer Rahmen 25 über die Nahtstelle 16 auf die Umfangsfläche 24 aufgeschoben, so daß auch hier die Bedingung erfüllt ist, daß die Nahtstelle 16 auf den gesamten Umfang des Targets 12 durch den metallischen Rahmen 25 abgedeckt ist, der gegenüber dem Target 12 eine Trennfuge 17 bildet. Die Trennfuge wird auch in diesem Fall zwischen der inneren Zylinderfläche des Rahmens 25 und der äußeren Zylinderfläche des Targets 12 gebildet und ist nicht mit Bond-Material ausgefüllt. Es ist zu erkennen, daß der innere Rand des Flansches 14a radial einwärts in der Nähe der Trennfuge 17 endet. Ferner ist auch hier die Bedingung erfüllt, daß die Trennfuge 17 außerhalb des von dem Magnetsystem (8, 9, 11) gebildeten magnetischen Tunnels liegt.

- 12 -

Während anhand der Figuren 1 und 2 primär rotationssymmetrische Zerstäubungskatoden erörtert wurden, gilt
das Prinzip der Anordnung naturgemäß auch für langgestreckte Katoden, d.h. für solche, die man sich beliebig in einer Richtung senkrecht zur Zeichenebene
verlängert denken kann. Man kann sich eine solche
langgestreckte Katode dadurch gebildet vorstellen,
daß man eine rotationssymmetrische Katode nach den
Figuren 1 und 2 entlang der Achse A-A diametral
durchtrennt und zwischen den beiden Hälften einen
Abstand bildet und diesen Abstand mit einem geradlinigen Katodenteil ausfüllt, dessen Querschnitt
exakt den Querschnitten in Figur 1 oder 2 entspricht.

ANSPRÜCHE:

1. Zerstäubungskatode mit einer Dunkelraumabschirmung für Vakuumbeschichtungsanlagen mit einem metallischen Katodengrundkörper und mit einem auf diesem durch Bonden befestigten Target, das mindestens teilweise, insbesondere an seiner Oberfläche, aus einem nicht-metallischen Werkstoff besteht, wobei eine zwischen Katodengrundkörper und Target gebildete, mit Bondmaterial gefüllte Nahtstelle an einem nicht der Glimmentladung ausgesetzten Ort angeordnet ist, dadurch gekennzeichnet, daß die Nahtstelle (16) auf dem gesamten Umfang des nicht-metallischen Targets (12) durch einen metallischen Rahmen (13, 25) abgedeckt ist, der auf Katodenpotential liegt und gegenüber dem Target (12) eine nicht mit Bondmaterial gefüllte Trennfuge (17) zwischen metallischem und nicht-metallischem Material bildet.

2. Zerstäubungskatode nach Anspruch 1, dadurch gekennzeichnet, daß der metallische Rahmen (13, 25) aus Kupfer besteht.

3. Zerstäubungskatode nach Anspruch 1, dadurch gekennzeichnet, daß der metallische Rahmen (13) mit dem Katodengrundkörper (5) in dessen Randbereich verschraubt ist.

4. Zerstäubungskatode nach Anspruch 3, <u>dadurch gekenn-
zeichnet</u>, daß das Target (12) und der Rahmen (13)
auf einer gemeinsamen ebenen Stirnfläche (7a) des
Katodengrundkörpers (5) befestigt sind und daß
die Höhe von Target (12) und Rahmen (13) in
Normalenrichtung zur Stirnfläche (7a) im wesentlichen gleich ist.

5. Zerstäubungskatode nach Anspruch 1, <u>dadurch gekenn-
zeichnet</u>, daß das Target (12) und der Katodengrundkörper (5) von einer gemeinsamen, zu dessen
Stirnfläche (22a) senkrecht verlaufenden Umfangsfläche (24) begrenzt sind, in der die Nahtstelle (16) liegt, und daß der metallische Rahmen (25)
über die Nahtstelle (16) auf die Umfangsfläche (24)
aufgeschoben ist.

6. Zerstäubungskatode nach Anspruch 1, <u>dadurch gekenn-
zeichnet</u>, daß bei einer Ausbildung der Zerstäubungskatode als Magnetronkatode mit einem
Magnetsystem die Trennfuge (17) außerhalb des
von dem Magnetsystem gebildeten magnetischen
Tunnels (10) bzw. des von diesem eingeschlossenen
Plasmas liegt.

## FIG.1

## FIG.2